# EUROPÄISCHE PATENTANMELDUNG

(11) **EP 1 820 880 A1**
(43) Veröffentlichungstag der Anmeldung: **22.08.2007**
(21) Anmeldenummer: 06002067.4
(22) Anmeldetag: 01.02.2006
(51) Int. Cl.: C23C 14/34

(54) **Pumpanordnung für eine Vakuumbeschichtungsanlage und Vakuumbeschichtungsanlage**

(71) Anmelder: Applied Materials GmbH & Co. KG, 63755 Alzenau (DE)
(72) Erfinder: Sauer, Andreas, 63762 Großostheim (DE)
(74) Vertreter: GROSSE BOCKHORNI SCHUMACHER

(57) **Zusammenfassung**

Bei einer Pumpanordnung (13) für eine Vakuumbeschichtungsanlage (1), insbesondere, einer zumindest abschnittsweise in Sputter-Up-Betrieb arbeitenden Vakuumbeschichtungsanlage mit wenigstens einer aufgeständerten, evakuierbaren Beschichtungskammer (2), einer Transporteinrichtung (4) zum Transportieren zu beschichtender Substrate (5) in einer Transportebene innerhalb der Beschichtungskammer (2) und wenigstens einem Beschichtungswerkzeug (6), wobei die Pumpanordnung einen im Bereich von Bodenöffnungen (9) der Beschichtungskammer mit der Beschichtungskammer verbindbaren Pumpdeckel (14) und wenigstens eine an dem Pumpdeckel angeordnete Vakuumpumpe (17, 17') aufweist, ist vorgesehen, dass der Pumpdeckel in Form einer Kammer ausgebildet ist. Eine erste Wand der Kammer weist dabei mit den Bodenöffnungen der Beschichtungskammer korrespondierende Pumpöffnungen (19) auf. Weiterhin ist die Vakuumpumpe an einer Stirnwand (15, 15') der Kammer angeordnet, sodass eine Saugöffnung (16, 16') der Vakuumpumpe senkrecht zu einer die Pumpöffnung enthaltenen Ebene angeordnet ist. Auf diese Weise ergibt sich ein flexibles Anlagenkonzept für Vakuumbeschichtungsanlagen mit einfacher Nachrüstmöglichkeit für Sputter-Up-Betrieb in beliebigen Teilbereichen (Kompartments) der Anlage bei minimierten Anlagenvolumen, minimierter Anlagenoberfläche und entsprechenden Fertigungs- und Bearbeitungskosten.

## Beschreibung

Die vorliegende Erfindung betrifft eine Pumpanordnung für eine Vakuumbeschichtungsanlage, insbesondere eine zumindest abschnittsweise im Sputter-Up-Betrieb arbeitende Vakuumbeschichtungsanlage mit wenigstens einer evakuierbaren Beschichtungskammer, einer Einrichtung zum Transportieren zu beschichtender Substrate in einer Transportebene innerhalb der Beschichtungskammer und wenigstens einem Beschichtungswerkzeug, wobei die Pumpanordnung einen im Bereich von Bodenöffnungen der Beschichtungskammer mit der Beschichtungskammer verbindbaren Pumpdeckel und wenigstens eine an dem Pumpdeckel angeordnete Vakuumpumpe aufweist.

Weiterhin betrifft die vorliegende Erfindung eine Vakuumbeschichtungsanlage zum Beschichten insbesondere längserstreckter Substrate, mit wenigstens einer aufgeständerten, evakuierbaren Beschichtungskammer, einer in der Beschichtungskammer angeordneten Substrat-Transporteinrichtung zum Transportieren eines zu beschichtenden Substrats in einer Transportebene und wenigstens einem unterhalb der Transportebene angeordneten, im Sputter-Up-Betrieb arbeitenden Beschichtungswerkzeug.

Vakuumtechnische Beschichtungsanlagen der vorstehend genannten Art werden heutzutage zur vielfältigen Beschichtung von Substraten, insbesondere zur Beschichtung längserstreckter Substrate, wie zum Beispiel Architekturglas, eingesetzt. Grundsätzlich ist dabei zu unterscheiden zwischen Vakuumbeschichtungsanlagen, bei denen die Beschichtung des Substrats von oberhalb einer Substratdurchfahrebene (Transportebene) im sogenannten Sputter-Down-Betrieb durchgeführt wird, und solchen Anlagen, bei denen die Beschichtung von unterhalb der Substratdurchfahrebene im sogenannten Sputter-Up-Betrieb erfolgt. Dabei ist bekannt, Sputter-Down-Beschichtungen und Sputter-Up-Beschichtungen in einer einzigen Vakuumbeschichtungsanlage durchzuführen, bei der entsprechend die evakuierbare Beschichtungskammer längs des Substrat-Transportweges in einzelne Beschichtungs-Abteilungen, sogenannte Kompartments, unterteilt ist.

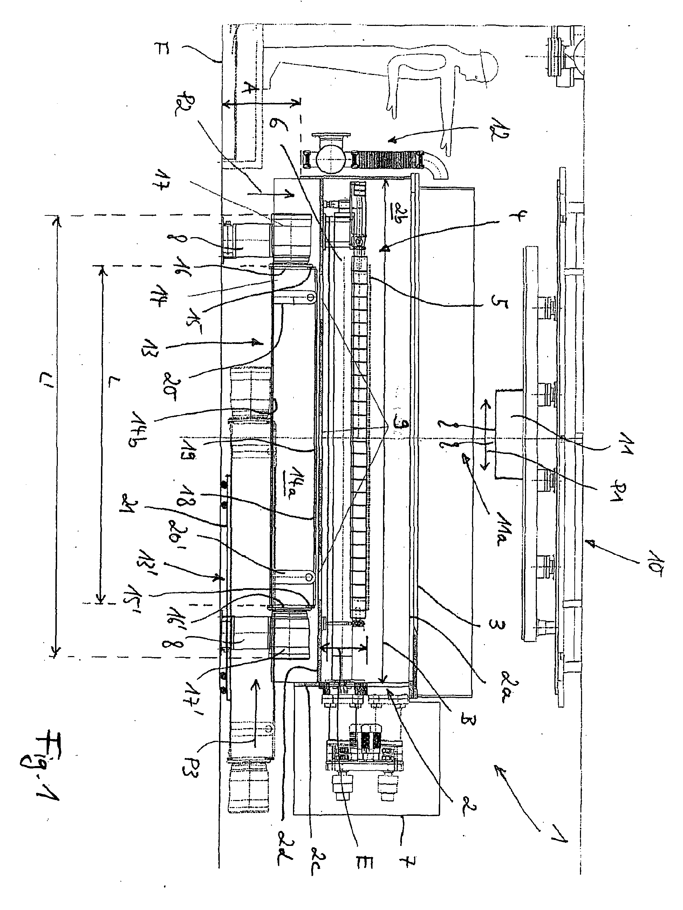

Gattungsgemäße Vakuumbeschichtungsanlagen sind beispielsweise aus der DE 103 52 143 A1 und der DE 103 52 144 A1 bekannt. Demgemäß werden vorbekannte Vakuumbeschichtungsanlagen, die für eine Beschichtung des Substrats von unterhalb der Substratdurchfahrebene, d.h. im Sputter-Up-Betrieb vorbereitet sind, nach dem Stand der Technik grundsätzlich wie folgt ausgeführt: Die Beschichtungskammer ist - wie dies beispielsweise der jeweiligen Figur 1 der vorgenannten Druckschriften entnehmbar ist - um ein gewisses Maß ausgehend von der Substratdurchfahrebene nach unten hin verlängert, sodass die Beschichtungswerkzeuge unterhalb der Substratdurchfahrebene Platz finden. Die verwendeten Beschichtungswerkzeuge enthalten regelmäßig eine mit elektrischer Energie versorgte Katode, wobei ein als Plasma bezeichnetes ionisiertes Gas erzeugt und zum Abtragen eines sogenannten Targets verwendet wird. Hierbei sind die Katode und das Target bezüglich des zu beschichtenden Substrats derart angeordnet, dass das aus dem Target herausgelöste Targetmaterial sich als Beschichtung auf dem Substrat niederschlägt. Zur Durchführung dieses Prozesses ist regelmäßig ein geeignetes (Ultra-)Hochvakuum erforderlich, das unter Verwendung von Hochvakuumpumpen, vorzugsweise Turbomolekularpumpen, und unter Vorschaltung eines entsprechenden Vorvakuums erzeugt wird.

Bei vorbekannten Vakuumbeschichtungsanlagen werden die Hochvakuumpumpen regelmäßig seitlich, d.h. rechts oder links der Katode oder auch direkt hinter bzw. unter der Katode an flachen sogenannten Deckeln im Bereich hierfür vorgesehener Öffnungen der Beschichtungskammer angebracht. In diesem Zusammenhang ist es erforderlich, die Beschichtungskammer um ein weiteres Maß nach unten zu verlängern, um die Vakuumpumpen horizontal an den Seitenwänden der Beschichtungskammer in Bodennähe platzieren zu können. Die Möglichkeit einer vertikalen Montage der Vakuumpumpen mit entsprechender Ausrichtung der Saugöffnung (Ansaugstutzen) nach oben direkt an den benötigten Stellen entfällt bei herkömmlichen Anlagen, da bei einer solchen Anordnung einerseits Staub und Schmutz in die Pumpe fallen würden und andererseits die Wartung oder Montage derartig angeordneter Pumpen bei einer typischen Anlagenbreite von 4 bis 5 m nur mit erhöhtem Aufwand möglich wäre.

In der Regel wird im Betrieb einer derartigen Vakuumbeschichtungsanlage nur ein Teil oder Abschnitt der Anlage, d.h. nur ein Bruchteil der Kompartmentanzahl im Sputter-Up-Verfahren betrieben. Um jedoch die Flexibilität der Anlage zu gewährleisten, muss die Anlage in ihrer Gesamtheit, d.h. jedes einzelne Kompartment entsprechend vorbereitet sein. Dies führt bei herkömmlichen Anlagen aufgrund der vorstehend beschriebenen baulichen Maßnahmen zu einem erhöhten Materialaufwand sowie erhöhten Fertigungskosten bei einem stark erhöhten Anlagenvolumen und entsprechend vergrößerter Oberfläche, was wiederum in nachteiliger Weise zusätzliche Anforderungen an die einzusetzenden Vakuumpumpen stellt.

In Abwandlung des vorstehend beschriebenen Anlagenkonzepts ist beispielsweise gemäß der DE 103 52 143 A1 vorgesehen, die Vakuumpumpen bei Sputter-Up-Betrieb der Anlage in jeweils zwischen abgetrennte Beschichtungssektionen (Kompartments) geschalteten Pumpsektionen anzuordnen. Auch dies führt zu einem erhöhten Materialaufwand und damit verbundenen erhöhten Fertigungskosten bei in nachteiliger Weise vergrößertem Anlagenvolumen.

Der Erfindung liegt die Aufgabe zu Grunde, ein flexibles Anlagenkonzept zu schaffen, das bei minimiertem Anlagenvolumen, minimierter Anlagenstellfläche und reduzierten Bearbeitungskosten einen Sputter-Up-Betrieb in beliebigen Teilabschnitten (Kompartments) einer gattungsgemäßen Vakuumbeschichtungsanlage ermöglicht.

Die Aufgabe wird bei einer Pumpanordnung der eingangs genannten Art dadurch gelöst, dass der Pumpdeckel als Kammer ausgebildet ist, die in einer ersten Wand wenigstens eine mit einer Bodenöffnung der Beschichtungskammer korrespondierende Pumpöffnung aufweist, und dass die Vakuumpumpe an einer Stirnwand der Kammer angeordnet ist, wobei eine Saugöffnung der Vakuumpumpe senkrecht zu einer die Pumpöffnung enthaltenen Ebene angeordnet ist.

Die Aufgabe wird bei einer Vakuumbeschichtungsanlage der eingangs genannten Art dadurch gelöst, dass in einem Boden der Beschichtungskammer wenigstens eine Bodenöffnung vorgesehen ist und dass im Bereich der Bodenöffnung eine erfindungsgemäße Pumpanordnung mit der Beschichtungskammer verbunden ist.

Nach einer Grundidee der vorliegenden Erfindung werden die (Hoch-)Vakuumpumpen an einem kammerförmig ausgebildeten, separaten Pumpdeckel montiert, der dann in eine entsprechende Stellung relativ zur Vakuumbeschichtungsanlage gebracht und dort montiert wird. Auf diese Weise sind das Volumen und die Innen-Oberfläche der Vakuumbeschichtungsanlage vorteilhafter Weise nur an denjenigen Stellen vergrößert, an denen dies für einen Sputter-Up-Betrieb der Anlage tatsächlich notwendig ist. Dadurch ergeben sich insbesondere deutliche Vorteile beim Evakuieren der Anlage. Aufgrund der Tatsache, dass die wenigstens eine Vakuumpumpe an einer Stirnwand der Pumpdeckel-Kammer angeordnet ist, wohingegen die Montage der Kammer selbst am Boden der Beschichtungskammer über eine erste Wand der Pumpdeckel-Kammer erfolgt, die senkrecht zu der Stirnwand und damit zur Saugöffnung (Ansaugstutzen) der Vakuumpumpe orientiert ist, wird die weiter oben beschriebene Problematik einer Verschmutzung der Vakuumpumpe sicher vermieden, sodass diese in für die Vakuumerzeugung vorteilhafter Weise direkt an den benötigten Stellen der Beschichtungskammer angebracht werden kann.

In Weiterbildung der erfindungsgemäßen Pumpanordnung ist vorgesehen, dass die Kammer des Pumpdeckels einen im Wesentlichen rechteckigen Querschnitt aufweist, sodass der Pumpdeckel in einfacher Weise an dem regelmäßig zumindest abschnittsweise ebenen Boden der Beschichtungskammer befestigt werden kann.

Um den Materialaufwand und das zum Errichten und Betreiben der erfindungsgemäßen Vakuumbeschichtungsanlage benötigte Bauvolumen gering zu halten, sieht eine Weiterbildung der erfindungsgemäßen Pumpanordnung vor, dass die Pumpdeckel-Kammer eine Längserstreckung aufweist, die kleiner ist als eine Abmessung der Beschichtungskammer quer zur Substrat-Transportrichtung. In vorteilhafter Weise sieht eine bevorzugte weitere Ausgestaltung der erfindungsgemäßen Pumpanordnung vor, dass die Kammer auch mit angesetzter Vakuumpumpe bzw. angesetzten Vakuumpumpen eine Längserstreckung aufweist, die kleiner ist als eine entsprechende Abmessung der Beschichtungskammer quer zur Substrat-Transportrichtung, sodass eine an der Beschichtungskammer montierte erfindungsgemäße Pumpanordnung nicht seitlich über die nominelle Breite der Vakuumbeschichtungsanlage / Beschichtungskammer hinaus ragt.

Für eine verbesserte Vakuumerzeugung sieht eine Weiterbildung der erfindungsgemäßen Pumpanordnung vor, dass an einander gegenüber liegenden Stirnwänden der Kammer jeweils mindestens eine Vakuumpumpe angeordnet ist. Vorzugsweise sind an einander gegenüber liegenden Stirnwänden der Kammer jeweils zwei Vakuumpumpen angeordnet.

Um weiterhin die Montage der erfindungsgemäßen Pumpanordnung im Bodenbereich der Beschichtungskammer einer Vakuumbeschichtungsanlage zu erleichtern, ist nach einer äußerst bevorzugten Weiterbildung der erfindungsgemäßen Pumpanordnung vorgesehen, dass im Innern der Kammer im Bereich der Pumpöffnung wenigstens eine durch die Pumpöffnung von außen zugängliche Einrichtung zum Anheben der Pumpanordnung vorgesehen ist. Dabei kann vorgesehen sein, dass die Anhebeeinrichtung als Befestigungseinrichtung, insbesondere in Form einer Anhängeöse, zum Befestigen eines Anhebemittels, wie einer Kette, eines Seils oder dergleichen, ausgebildet ist. Auf diese Weise ist erfindungsgemäß ein besonders einfaches Bewegen der Pumpanordnung in vertikaler Richtung möglich.

In diesem Zusammenhang weist eine entsprechende Weiterbildung der erfindungsgemäßen Vakuumbeschichtungsanlage eine oberhalb der Beschichtungskammer vorgesehene Hebeeinrichtung zum Anheben der Pumpanordnung gegen den Boden der Beschichtungskammer durch die in einem Deckelbereich geöffnete Beschichtungskammer und die wenigstens eine Bodenöffnung der Beschichtungskammer auf.

Um die erfindungsgemäße Pumpeinrichtung auch in horizontaler Richtung für die Montage im Bodenbereich der Beschichtungskammer einer Vakuumbeschichtungsanlage einfach und sicher bewegen zu können, sind gemäß einer weiteren Ausgestaltung der erfindungsgemäßen Pumpanordnung an dieser Transportrollen zum horizontalen Bewegen der Pumpanordnung vorgesehen. Alternativ oder zusätzlich kann die erfindungsgemäße Pumpanordnung für den horizontalen Transport jedoch auch auf einer separaten Transporteinrichtung, wie einem Hubwagen oder dergleichen, anordenbar und transportierbar sein.

In entsprechender Weiterbildung der erfindungsgemäßen Vakuumbeschichtungsanlage ist daher vorgesehen, dass diese eine Transporteinrichtung, wie einen Hubwagen oder dergleichen, für den horizontalen Transport der Pumpanordnung in den Bereich der wenigstens einen Bodenöffnung der Beschichtungskammer aufweist, durch die hindurch die Pumpanordnung anschließend - wie vorstehend beschrieben - zur Montage an der Beschichtungskammer anhebbar ist.

Je nach Lage und Anordnung der Bodenöffnungen der Beschichtungskammer kann die vorstehend beschriebene erfindungsgemäße Pumpanordnung in flexibler Weise in unterschiedlichen Positionen und Anordnungen relativ zur Beschichtungskammer bzw. dem darin enthaltenen Beschichtungswerkzeug angeordnet werden. So sieht eine erste Weiterbildung der erfindungsgemäßen Vakuumbeschichtungsanlage vor, dass die wenigstens eine Bodenöffnung der Beschichtungskammer unterhalb des Beschichtungswerkzeugs angeordnet ist. Alternativ oder zusätzlich kann jedoch vorgesehen sein, dass die Bodenöffnung der Beschichtungskammer relativ zu dem Beschichtungswerkzeug versetzt angeordnet ist, d.h. sich bezogen auf eine Subtrat-Transportrichtung vor bzw. hinter dem Beschichtungswerkzeug befindet.

Um bei der Anlagenfertigung weitere Kosten zu sparen, sind an den Schnittstellen zwischen Beschichtungskammer und Pumpdeckel, d.h. im Bereich der Bodenöffnungen bzw. Pumpöffnungen keine durchgehenden Öffnungen, sondern nur einzelne, vorzugsweise runde Verbindungsöffnungen vorgesehen. Neben deren vorstehend beschriebener Anordnung sind darüber hinaus Anzahl und Größe der Öffnungen so dimensioniert, dass bei der Vakuumerzeugung keine negativen Auswirkungen auf Leitwert und Querverteilung resultieren. Insbesondere kann dabei in Weiterbildung der erfindungsgemäßen Vakuumbeschichtungsanlage vorgesehen sein, dass eine Mehrzahl von Bodenöffnungen im Boden der Beschichtungskammer vorgesehen sind, wobei eine Anzahl von Öffnungen jeweils in einer Reihe quer zu einer Transportrichtung des Substrats angeordnet sind.

Im Zuge der bereits erwähnten, flexiblen Einsetzbarkeit ist bei einer erfindungsgemäßen Vakuumbeschichtungsanlage vorteilhafter Weise weiterhin vorgesehen, dass die Beschichtungskammer in eine Anzahl von Abteilungen (Kompartments) unterteilt ist, die jeweils separat mit einer erfindungsgemäßen Pumpanordnung verbindbar sind.

Zur Minimierung des zu evakuierenden Anlagenvolumens ist nach einer äußerst bevorzugten Weiterbildung der erfindungsgemäßen Vakuumbeschichtungsanlage vorgesehen, dass ein Abstand zwischen der Substrat-Transportebene und dem Boden der Beschichtungskammer im Wesentlichen einem Einbauraum für das Beschichtungswerkzeug in einem geeignetem Target-Substrat-Abstand entspricht. Das Beschichtungswerkzeug kann dabei insbesondere als rotierende Katoden-Target-Anordnung ausgebildet sein.

Um die erfindungsgemäße Pumpanordnung bei Bedarf problemlos in einen dafür vorgesehen Montageraum unterhalb der aufgeständerten Beschichtungskammer einbringen bzw. daraus wieder entnehmen zu können, ist in Weiterbildung der erfindungsgemäßen Vakuumbeschichtungsanlage vorgesehen, dass eine Ständerhöhe im Wesentlichen bzw, mindestens einer entsprechenden Abmessung der Pumpdeckel-Kammer der Pumpanordnung in dieser Richtung entspricht.

Zum Erleichtern einer flexiblen Umkonfiguration der erfindungsgemäßen Vakuumbeschichtungsanlage ist in Weiterbildung vorgesehen, dass diese wenigstens eine entlang der Beschichtungskammer bewegliche Anschlusseinheit aufweist, die zum Schaffen eines Vorvakuumanschlusses und / oder eines Wasseranschlusses, insbesondere zum Kühlen des Beschichtungswerkzeugs, und / oder eines Stromanschlusses, insbesondere zur Energieversorgung des Beschichtungswerkzeugs oder dergleichen, im Bereich des Beschichtungswerkzeugs mit der Beschichtungskammer bzw. der wenigstens einen Vakuumpumpe verbindbar ist.

Weitere Eigenschaften und Vorteile der vorliegenden Erfindung ergeben sich aus der nachfolgenden Beschreibung eines Ausführungsbeispiels anhand der Zeichnung. Es zeigt:
- Fig. 1: eine Schnittansicht der erfindungsgemäßen Vakuumbeschichtungsanlage quer zu einer Transportrichtung eines zu beschichtenden Substrats; und
- Fig. 2: eine detaillierte Schnittansicht eines Teils der erfindungsgemäßen Vakuumbeschichtungsanlage längs der Transportrichtung eines zu beschichtenden Substrats.

Die Fig. 1 zeigt eine schematische Schnittansicht einer erfindungsgemäßen Vakuumbeschichtungsanlage 1 quer zu einer senkrecht zur Blattebene verlaufenden Transportrichtung für ein zu beschichtendes Substrat im Inneren der Vakuumbeschichtungsanlage 1. Die Vakuumbeschichtungsanlage 1 besitzt eine evakuierbare Beschichtungskammer 2, die an ihrer Oberseite eine Öffnung 2a aufweist, die gemäß der Fig. 1 mittels eines Kammerdeckels 3 verschlossen ist. Im Inneren 2b der Beschichtungskammer 2 ist in an sich bekannter Weise eine Substrat-Transporteinrichtung 4 zum Transportieren eines längserstreckten Substrats 5 in einer in die Zeichenebene hinein bzw. aus dieser heraus verlaufenden Transportebene vorgesehen. Wie dem Fachmann bekannt ist, weist eine Vakuumbeschichtungsanlage 1 der in Fig. 1 gezeigten Art für den Transport lang gestreckter Substrate 5 eine Transporteinrichtung 4 mit einer Abfolge von einzelnen hintereinander angeordneten Transporteinheiten 4a (Rolleneinheiten) auf, was aus der Schnittansicht der Fig. 1 jedoch nicht ersichtlich ist.

Unterhalb der Transportebene des Substrats 5 weist die Vakuumbeschichtungsanlage 1 ein Beschichtungswerkzeug 6 auf, das nach dem gezeigten Ausführungsbeispiel als rotierende Katode bzw. rotierende Target-Katoden-Anordnung ausgebildet ist. Wie der Fachmann weiß, kann eine Vakuumbeschichtungsanlage 1 der in Fig. 1 gezeigten Art in Transportrichtung des Substrats 5 eine Abfolge mehrerer derartiger Beschichtungswerkzeuge 6 und / oder auch weitere, oberhalb der Transportebene angeordenete Sputter-Down-Beschichtungswerkzeuge aufweisen, was wiederum aus der gewählten Darstellungsform nicht ersichtlich ist. Für das Beschichtungswerkzeug 6 und / oder zumindest die Transporteinheit 4a weist die gezeigte Vakuumbeschichtungsanlage 1 eine geeignete Antriebseinheit 7 auf.

Die Beschichtungskammer 2 ist mittels einer Anzahl von Ständern 8 aufgeständert, sodass ein bestimmter Abstand A zwischen einer unteren Verlängerung von Seitenwänden 2c der Beschichtungskammer 2 und der Aufstellfläche F (Bodenfläche) am Aufstellort der Vakuumbeschichtungsanlage 1 resultiert. In ihrem Boden 2d besitzt die Beschichtungskammer 2 eine Mehrzahl von Bodenöffnungen 9 mit kreisförmigem Querschnitt, die beim Ausführungsbeispiel der Fig. 1 in einer Reihe quer zur Transportrichtung des Substrats 5 angeordnet sind. Ein Abstand E zwischen der Substrat-Durchfahrebene und dem Boden 2d der Beschichtungskammer 2 ist so gewählt, dass er im Wesentlichen einem Einbauraum für das Beschichtungswerkzeug 6 in einem geeigneten Target-Substrat-Abstand zum Substrat 5 entspricht.

Oberhalb der Beschichtungskammer 2 weist die Vakuumbeschichtungsanlage 1 eine mit einer nicht gezeigten Deckenkonstruktion am Aufstellort der Vakuumbeschichtungsanlage 1 in Verbindung stehende Aufhängung 10 auf, an der eine in Richtung des Doppelpfeils P1 bewegliche Hebeeinrichtung 11 in Form eines Hallenkrans angeordnet ist.

Weiterhin besitzt die gezeigte Vakuumbeschichtungsanlage 1 zumindest eine Anschlusseinheit 12, die einen Vorvakuumanschluss sowie in nicht explizit dargestellter Weise einen Wasseranschluss und einen Stromanschluss umfasst und als komplette Einheit entlang der Beschichtungskammer 2, d.h. senkrecht zur Blattebene beweglich ist, worauf später noch detailliert eingegangen wird.

Wie dem Fachmann geläufig ist, kann die Beschichtungskammer 2 der dargestellten Vakuumbeschichtungsanlage 1 in der Transportrichtung des Substrats 5 in einzelne, voneinander getrennte Abteilungen (Kompartments) unterteilt sein, in denen jeweils Beschichtungsvorgänge unabhängig voneinander ablaufen können. Dementsprechend zeigt die Schnittansicht gemäß der Fig. 1 insbesondere einen Schnitt durch ein derartiges Kompartment der Vakuumbeschichtungsanlage 1, wobei der Innenraum 2b der Beschichtungskammer 2 dem Kompartment-Innenraum entspricht.

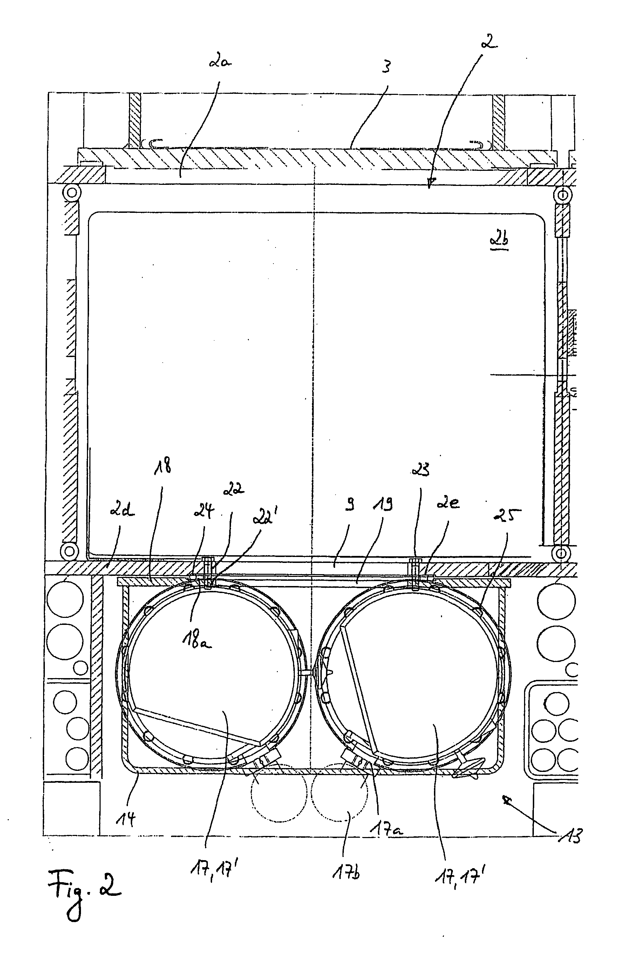

Erfindungsgemäß weist die Vakuumbeschichtungsanlage 1 in einem Bereich unterhalb des Bodens 2d der Beschichtungskammer 2 bzw. eines entsprechenden Kompartments der Vakuumbeschichtungsanlage 1 eine erfindungsgemäße Pumpanordnung 13 auf, die nachfolgend detailliert beschrieben ist:
Die Pumpanordnung 13 besitzt zunächst einen Pumpdeckel 14, der gemäß dem gezeigten Ausführungsbeispiel in Form eines langgestreckten Kastens bzw. einer langgestreckten Kammer mit rechteckigem Querschnitt ausgebildet ist. An einander gegenüber liegenden Stirnwänden 15, 15' weist der Pumpdeckel 14 (im Nachfolgenden auch als "Kammer" oder "Pumpdeckel-Kammer" bezeichnet), jeweils mindestens eine Saugöffnung 16, 16' auf, hinter der - außen mit der Kammer 14 bzw. deren Stirnwand 15, 15' verbunden - jeweils eine Hochvakuumpumpe in Form einer Turbomolekularpumpe 17, 17' angeordnet ist. Dabei können - wie der gewählten Darstellung wiederum nicht zu entnehmen ist - auf beiden Seiten der Kammer 14 jeweils mehrere Saugöffnungen 16, 16' und entsprechend mehrere Turbomolekularpumpen 17, 17' hintereinander angeordnet sein (vgl. Fig. 2). An seiner oberen Wand 18 besitzt der Pumpdeckel 14 eine Reihe von Pumpöffnungen 19, die von ihren Abmessungen und ihrer relativen Anordnung her mit den bereits erwähnten Bodenöffnungen 9 im Boden 2d der Beschichtungskammer 2 korrespondieren, wobei die Pumpöffnungen 19 in einer gemeinsamen Ebene angeordnet sind, die senkrecht zu den Saugöffnungen 16, 16' und damit zu einer Öffnung der jeweiligen Turbomolekularpumpen 17, 17' orientiert ist.

Zur Evakuierung des Innenraums 2b der Beschichtungskammer 2 wird die Pumpanordnung 13 mit der oberen Wand 18 der Pumpdeckel-Kammer 14 am Boden 2d der Beschichtungskammer 2 im Bereich der Bodenöffnungen 9 und der Pumpöffnungen 19 in Anlage an die Beschichtungskammer 2 gebracht, sodass sich die Bodenöffnungen 9 und die Pumpöffnungen 19 überdecken, wie aus der Fig. 1 ersichtlich ist. Dieser Aspekt sowie eine entsprechende Befestigung der Pumpanordnung 13 an der Beschichtungskammer 2 wird weiter unten unter Bezugnahme auf die Fig. 2 noch detailliert beschrieben.

In seinem Innenraum 14a verfügt der Pumpdeckel 14 unterhalb einer Anzahl von Pumpöffnungen 19 und über diese von außen zugänglich über Befestigungseinrichtungen 20 , 20' in Form von Anhängeösen, die zum Anheben der Pumpanordnung 13 nach oben gegen den Boden 2d der Beschichtungskammer 2, d.h. in Richtung des Pfeils P2 mit der bereits erwähnten Hebeeinrichtung 11 zusammenwirken können. Die Hebeeinrichtung 11 weist hierzu in an sich bekannter Weise Anhebemittel 11 a, wie Ketten, Seile oder dergleichen auf, die zum Einhängen in die Befestigungseinrichtungen 20, 20' (Anhängeösen) der Pumpanordnung 13 vorzugsweise mit einem Haken oder dergleichen versehen sind.

Um die Pumpanordnung 13 aus einer in der Fig. 1 gestrichelt dargestellten demontierten Stellung 13' in die vorstehend detailliert erläuterte Montagestellung am Boden 2d der Beschichtungskammer 2 zu bewegen, ist neben der durch die Hebeeinrichtung 11 bewirkten vertikalen Anhebebewegung in Richtung des Pfeils P2 zunächst eine horizontale Bewegung der Pumpanordnung in Richtung des Pfeils P3 erforderlich. Hierzu ist gemäß dem gezeigten Ausführungsbeispiel der Vakuumbeschichtungsanlage 1 eine separate Transporteinrichtung 21 in Form eines Hubwagens vorgesehen, durch den bzw. auf dem die Pumpanordnung aus der Stellung 13' in eine Stellung unterhalb der Bodenöffnungen 9 der Beschichtungskammer 2 verbringbar ist, sodass sie dann - wie vorstehend eingehend beschrieben - mittels der Hebeeinrichtung 11 bei entsprechend geöffnetem Kammerdeckel 3 durch die Öffnung 2a der Beschichtungskammer 2 und die Pumpöffnungen 9 in Richtung des Pfeils P2 nach oben bewegbar ist.

Nach dem gezeigten Ausführungsbeispiel der Fig. 1 weist der Pumpdeckel 14 eine Längserstreckung L, d.h. eine Erstreckung quer zur Substrat-Transportrichtung der Vakuumbeschichtungsanlage 1 auf, die kleiner ist als eine entsprechende Abmessung (Breite) B der Beschichtungskammer 2. Auch eine Längserstreckung L' der gesamten Pumpanordnung 13, d.h. Kammer 14 mit stirnseitig montierten Turbomolekularpumpen 17, 17' ist erfindungsgemäß kleiner als die Breite B der Beschichtungskammer 2. Der weiter oben beschriebene Abstand A der Beschichtungskammer 2 von der Aufstellfläche F ist ausreichend, um die Pumpanordnung 13 in horizontaler Richtung, d.h. in Richtung des Pfeils P3 auf dem Hubwagen 21 in den Bereich unterhalb der Beschichtungskammer 2 hinein und aus diesen heraus zu bewegen, wie ebenfalls aus der Fig. 1 ersichtlich ist.

Zusätzlich oder alternativ zu der vorstehend beschriebenen Hubwagen-Lösung kann die Pumpanordnung 13 auch an der Unterseite 14b des Pumpdeckels 14 eine Anzahl von Rolleneinheiten (nicht gezeigt) aufweisen, sodass die Pumpanordnung 13 auch ohne Hubwagen 21 in horizontaler Richtung, d.h. in Richtung des Pfeils P3 unter die Beschichtungskammer 2 bewegbar ist.

Die Fig. 2 zeigt anhand einer detaillierten Schnittansicht längs der Transportrichtung des Substrats 5 in Fig. 1 die Montage der Pumpanordnung 13 am Boden 2d der Beschichtungskammer 2. In der Darstellung der Fig. 2 sind bereits anhand der Fig. 1 besprochene Elemente der erfindungsgemäßen Vakuumsbeschichtungsanlage 1 bzw. Pumpanordnung 13 mit denselben Bezugszeichen versehen. Gemäß der Fig. 2 weisen sowohl der Boden 2d der Beschichtungskammer 2 als auch die obere Wand 18 des Pumpdeckels 14 im Umfangsbereich der jeweiligen korrespondierenden Öffnungen (Bodenöffnungen 9 bzw. Pumpöffnungen 19) eine Anzahl von Bohrungen 22 bzw 22' auf, in die vom Innenraum 2b der Beschichtungskammer 2 her Befestigungsschrauben 23 zum Befestigen der Pumpanordnung 13 bzw. der Kammer 14 am Boden 2d der Beschichtungskammer 2 einbringbar sind. Zu Dichtzwecken weisen sowohl der Boden 2d als auch die obere Wand 18 der Kammer 14 entsprechende Dichtflächen 2e bzw. 18a auf, zwischen die gemäß der Fig. 2 ein umlaufender Dichtring 24 einbringbar ist.

Wie die Fig. 2 weiterhin zeigt, sind an den Stirnwänden 15, 15' (Fig. 1) der Kammer 14 jeweils zwei Turbomolekularpumpen 17, 17' nebeneinander angeordnet. Diese sind gemäß Herstellervorgaben bei der für den Betrieb von Vakuumbeschichtungsanlagen der gezeigten Art benötigten Pumpengröße mit jeweils zwölf Befestigungsbohrungen (bei der gewählten Darstellung nicht erkennbar) und entsprechenden Befestigungsschrauben 25 an den jeweiligen Stirnwänden 15, 15' (Fig. 1) des Pumpdeckels 14 befestigt. Weiterhin sind in der Fig. 2 noch die jeweiligen Anschlussflansche 17a und Abgangsanschlüsse 17b für das Vorvakuum dargestellt. Letztere sind insbesondere zum Verbinden mit der bereits anhand der Fig. 1 erläuterten beweglichen Anschlusseinheit 12 vorgesehen. Jedoch liegt die Anzahl der vorzusehenden Turbomolekularpumpen sowie die Menge bzw. Abmessungen der vorzusehenden Öffnungen (Bodenöffnungen 9 bzw. Pumpöffnungen 19) im Bereich des Fachwissens des maßgeblichen Fachmanns für Vakuumbeschichtungstechnik und werden insbesondere durch die vorgegebenen Richtwerte für Querverteilung und Leitwert und somit die Güte des zu erreichenden Vakuums bestimmt.

Auf diese Weise ist im Rahmen der erfindungsgemäßen Vakuumbeschichtungsanlage 1 eine hochgradig flexible Einsetzbarkeit der Anlage verbunden mit einer sehr kostengünstigen Möglichkeit der Vorbereitung einzelner Abteilungen / Kompartments der Beschichtungskammer für eine (spätere) Nutzung im Sputter-Up-Betrieb gegeben. Bei vorbekannten Anlagenkonzepten müssen zu diesem Zweck insbesondere die jeweils zwölf vorgeschriebenen Befestigungsbohrungen zum Anbringen einer Turbomolekularpumpe an jeder möglichen Einbauposition, d.h. beispielsweise im Bereich einer jeden Bodenöffnung 9 der Beschichtungskammer 2 vorgesehen werden. Im Rahmen der erfindungsgemäßen "Deckellösung" sind derartige Befestigungsbohrungen am Pumpdeckel 14 angebracht (vgl. Fig. 2) und somit nur dann und dort vorhanden, wenn bzw. wo sie benötigt werden. Die anhand der Fig. 2 detailliert beschriebenen Verbindungsöffnungen (Bodenöffnungen 9 bzw. Pumpöffnungen 19) zwischen Pumpdeckel 14 und Beschichtungskammer 2 können demgegenüber wesentlich einfacher und kostengünstiger gestaltet werden. Auf diese Weise ist die Vorbereitung der erfindungsgemäßen Vakuumbeschichtungsanlage 1 für den Sputter-Up-Betrieb nur unwesentlich teurer als eine herkömmliche Sputter-Down-Anlage.

Weiterhin wird im Rahmen der vorliegenden Erfindung das Volumen und entsprechend die Innen-Oberfläche der Vakuumbeschichtungsanlage durch das Anbringen der beschriebenen Pumpanordnung nur an den Stellen vergrößert, an denen es im Zuge einer Sputter-Up-Beschichtung wirklich notwendig ist. Auf diese Weise ergeben sich entscheidende Vorteile beim Evakuieren der Anlage.

Aufgrund der Tatsache, dass die Anschlusseinheit 12 (Fig. 1) als komplette Einheit bewegt werden kann, wird zudem eine Umkonfiguration der Anmeldung erfindungsgemäß wesentlich erleichtert.

### Bezugszeichenliste

- 1: Vakuumbeschichtungsanlage
- 2: Beschichtungskammer
- 2a: Öffnung
- 2b: Innenraum
- 2c: Seitenwand-Verlängerung
- 2d: Boden
- 2e: Dichtfläche
- 3: Kammerdeckel
- 4: Transporteinrichtung
- 4a: Rolleneinheit
- 5: Substrat
- 6: Beschichtungswerkzeug
- 7: Antriebseinheit
- 8: Ständer
- 9: Bodenöffnung
- 10: Aufhängung
- 11: Hebeeinrichtung
- 11a: Anhebemittel
- 12: Anschlusseinheit
- 13, 13': Pumpanordnung
- 14: Pumpdeckel, -Kammer
- 14a: Innenraum
- 14b: Unterseite
- 15, 15': Stirnwand
- 16, 16': Saugöffnung
- 17, 17': Vakuumpumpe, Turbomolekularpumpe
- 17a: Anschlussflansch
- 17b: Abgangsanschluss
- 18: obere Wand
- 18a: Dichtfläche
- 19: Pumpöffnung
- 20, 20': Befestigungseinrichtung, Anhängeöse
- 21: Transporteinrichtung, Hubwagen
- 22, 22': Befestigungsbohrung
- 23: Befestigungsschraube
- 24: Dichtring
- 25: Befestigungsschraube
- A: Abstand
- B: Breite
- E: Einbauraum
- F: Aufstellfläche
- L, L': Längserstreckung
- P 1: Bewegungsrichtung
- P2: Bewegungsrichtung
- P3: Bewegungsrichtung

## Patentansprüche

1. Pumpanordnung (13) für eine Vakuumbeschichtungsanlage (1), insbesondere eine zumindest abschnittsweise im Sputter-Up-Betrieb arbeitende Vakuumbeschichtungsanlage (1) mit wenigstens einer evakuierbaren Beschichtungskammer (2), einer Transporteinrichtung (4) zum Transportieren zu beschichtender Substrate (5) in einer Transportebene innerhalb der Beschichtungskammer (2) und wenigstens einem Beschichtungswerkzeug (6), aufweisend:
- einen im Bereich von Bodenöffnungen (9) der Beschichtungskammer (2) mit der Beschichtungskammer verbindbaren Pumpdeckel (14) und
- wenigstens eine an dem Pumpdeckel (14) angeordnete Vakuumpumpe (17, 17'),
**dadurch gekennzeichnet, dass** der Pumpdeckel (14) als Kammer ausgebildet ist, die in einer ersten Wand (18) wenigstens eine mit einer Bodenöffnung der Beschichtungskammer (2) korrespondierende Pumpöffnung (19) aufweist, und dass die wenigstens eine Vakuumpumpe (17, 17') an einer Stirnwand (15, 15') der Kammer (14) angeordnet ist, wobei eine Saugöffnung (16, 16') der Vakuumpumpe (17, 17') senkrecht zu einer die Pumpöffnung (19) enthaltenen Ebene angeordnet ist.

2. Pumpanordnung nach Anspruch 1, **dadurch gekennzeichnet, dass** die Kammer (14) einen im Wesentlichen rechteckigen Querschnitt aufweist.

3. Pumpanordnung nach Anspruch 1 oder 2, **dadurch gekennzeichnet, dass** die Kammer (14) eine Längserstreckung (L) aufweist, die kleiner ist als eine Abmessung (B) der Beschichtungskammer (2) quer zu einer Substrat-Transportrichtung.

4. Pumpanordnung nach einem der Ansprüche 1 bis 3, **dadurch gekennzeichnet, dass** die Kammer (14) mit angesetzter Vakuumpumpe (17, 17') eine Längserstreckung (L') aufweist, die kleiner ist als eine Abmessung (B) der Beschichtungskammer (2) quer zu einer Substrat-Transportrichtung.

5. Pumpanordnung nach einem der Ansprüche 1 bis 4, **dadurch gekennzeichnet, dass** an einander gegenüber liegenden Stirnwänden (15, 15') der Kammer (14) jeweils mindestens eine Vakuumpumpe (17, 17') angeordnet ist.

6. Pumpanordnung nach einem der Ansprüche 1 bis 5, **dadurch gekennzeichnet, dass** in einem Innenraum (14a) der Kammer (14) im Bereich der Pumpöffnung (19) wenigstens eine durch die Pumpöffnung von außen zugängliche Einrichtung (20, 20') zum Anheben der Pumpanordnung (13) vorgesehen ist.

7. Pumpanordnung nach Anspruch 6, **dadurch kennzeichnet, dass** die Anhebeeinrichtung (20, 20') als Befestigungseinrichtung, insbesondere in Form einer Anhängeöse, zum Befestigen eines Anhebemittels, wie einer Kette, eines Seils oder dergleichen, ausgebildet ist.

8. Pumpanordnung nach einem der Ansprüche 1 bis 7, **gekennzeichnet durch** Transportrollen zum horizontalen Bewegen der Pumpanordnung (13).

9. Pumpanordnung nach einem der Ansprüche 1 bis 8, **dadurch gekennzeichnet, dass** die Pumpanordnung (13) für den horizontalen Transport auf einer Transporteinrichtung (21), wie einem Hubwagen, anordenbar ist.

10. Vakuumbeschichtungsanlage (1) zum Beschichten insbesondere längserstreckter Substrate (5), mit:
- wenigstens einer evakuierbaren, aufgeständerten Beschichtungskammer (2),
- einer in der Beschichtungskammer (2) angeordneten Substrat-Transporteinrichtung (4) zum Transportieren eines zu beschichtenden Substrats (5) in einer Transportebene und
- wenigstens einem unterhalb der Transportebene angeordneten, in Sputter-Up-Betrieb arbeitenden Beschichtungswerkzeug (6),
**dadurch gekennzeichnet, dass** in einem Boden (2c) der Beschichtungskammer (2) wenigstens eine Bodenöffnung (9) vorgesehen ist und dass im Bereich der Bodenöffnung (9) eine Pumpanordnung (13) nach einem der Ansprüche 1 bis 9 mit der Beschichtungskammer (2) verbunden ist.

11. Vakuumbeschichtungsanlage nach Anspruch 10, **dadurch gekennzeichnet, dass** die Bodenöffnung (9) unterhalb des Beschichtungswerkzeugs (6) angeordnet ist.

12. Vakuumbeschichtungsanlage nach Anspruch 10 oder 11, **dadurch gekennzeichnet, dass** die Bodenöffnung (9) relativ zu dem Beschichtungswerkzeug (6) versetzt angeordnet ist.

13. Vakuumbeschichtungsanlage nach einem der Ansprüche 10 bis 12, **dadurch gekennzeichnet, dass** das Beschichtungswerkzeug (6) als rotierende Katoden-Target-Anordnung ausgebildet ist.

14. Vakuumbeschichtungsanlage nach einem der Ansprüche 10 bis 13, **dadurch gekennzeichnet, dass** eine Mehrzahl von Bodenöffnungen (9) vorgesehen ist, wobei eine Anzahl der Bodenöffnungen (9) jeweils in einer Reihe quer zu einer Transportrichtung des Substrats (5) angeordnet sind.

15. Vakuumbeschichtungsanlage nach einem der Ansprüche 10 bis 14, **dadurch gekennzeichnet, dass** die Beschichtungskammer (2) in eine Anzahl von Abteilungen unterteilt ist, die jeweils separat mit einer Pumpanordnung (13) nach einem der Ansprüche 1 bis 9 verbindbar sind.

16. Vakuumbeschichtungsanlage nach einem der Ansprüche 10 bis 15, **dadurch gekennzeichnet, dass** ein Abstand (E) zwischen der Transportebene des Substrats (5) und dem Boden (2d) der Beschichtungskammer (2) im Wesentlichen einem Einbauraum für das Beschichtungswerkzeug (6) in einem geeigneten Target-Substrat-Abstand entspricht.

17. Vakuumbeschichtungsanlage nach einem der Ansprüche 10 bis 16, **dadurch gekennzeichnet, dass** eine Ständerhöhe (A) im Wesentlichen einer Abmessung der Kammer (14) der Pumpanordnung (13) in dieser Richtung entspricht.

18. Vakuumbeschichtungsanlage nach einem Ansprüche 1 bis 17, **gekennzeichnet durch** eine oberhalb der Beschichtungskammer (2) vorgesehene Hebeeinrichtung (11), die zum Anheben der Pumpanordnung (13) gegen den Boden (2d) der Beschichtungskammer (2) **durch** die in einem Deckelbereich (2a, 3) geöffnete Beschichtungskammer (2) und die wenigstens eine Bodenöffnung (9) ausgebildet ist.

19. Vakuumbeschichtungsanlage nach einem der Ansprüche 10 bis 18, **gekennzeichnet durch** eine Transporteinrichtung (21), wie einen Hubwagen, für den horizontalen Transport der Pumpanordnung (13) in den Bereich der Bodenöffnung (9).

20. Vakuumbeschichtungsanlage nach einem der Ansprüche 1 bis 19, **gekennzeichnet durch** wenigstens eine entlang der Beschichtungskammer (2) bewegliche Anschlusseinheit (12), die zum Schaffen eines Vorvakuumanschlusses und / oder eines Wasseranschlusses und / oder eines Stromanschlusses oder dergleichen im Bereich des Beschichtungswerkzeugs (6) mit der Beschichtungskammer (2) und / oder der Vakuumpumpe (17, 17') verbindbar ist.
